# EUROPÄISCHE PATENTSCHRIFT

(11) **EP 0 344 514 B1**
(45) Veröffentlichungstag und Bekanntmachung des Hinweises auf die Patenterteilung: **05.10.1994**
(21) Anmeldenummer: 89108868.4
(22) Anmeldetag: 17.05.1989
(51) Int. Cl.: H01L 29/743, H01L 29/10

(54) **Abschaltbarer Thyristor**
GTO thyristor
Thyristor à commande d'extinction

(30) Priorität: 31.05.1988 DE 3818516
(43) Veröffentlichungstag der Anmeldung: 06.12.1989
(73) Patentinhaber: SIEMENS AKTIENGESELLSCHAFT, 80333 München (DE)
(72) Erfinder: Oppermann, Klaus-Günther, Dipl.-Phys., D-8150 Holzkirchen (DE); Stengl, Reinhard, Dr., D-8000 München 2 (DE)

(56) Entgegenhaltungen:
- EP-A- 0 009 367
- EP-A- 0 129 702
- IEEE INTERNATIONAL ELECTRON DEVICES MEETING 1985, Washington, 1985, Seiten 158-161; M. STOISIEK et al.: "MOS GTO - A turn off thyristor with MOS-controlled emitter shorts"
- PATENT ABSTRACTS OF JAPAN, Band 6, Nr. 164 (E-127)[1042], 27. August 1982 ; & JP-A-57 83 057

## Beschreibung

Die Erfindung bezieht sich auf einen abschaltbaren Thyristor nach den Oberbegriffen der Patentansprüche 1 oder 2.

Thyristoren dieser Art sind aus der EP-A 0 009 367 und aus dem Aufsatz von M. Stoisiek und H. Strack "MOS GTO - a Turn-off Thyristor with MOS-controlled Emitter Shorts", veröffentlicht im IEDM-Report 1985, Seiten 158 bis 161, bekannt. Beim Abschalten solcher Thyristoren zeigt es sich, daß der abschaltbare Strom bei einer Erhöhung der zwischen der anoden- und kathodenseitigen Elektrode anliegenden Spannung deutlich abnimmt.

Der Erfindung liegt die Aufgabe zugrunde, einen Thyristor der eingangs genannten Art anzugeben, der die Abschaltung eines höheren Stromes ermöglicht als das bei den herkömmlichen Thyristoren der Fall ist, wobei dies insbesondere auch bei höheren Werten der anliegenden Anoden-Kathoden-Spannung gewährleistet sein soll. Das wird erfindungsgemäß durch eine Ausbildung nach den kennzeichnenden Teilen der Patentansprüche 1 und 2 erreicht.

Der mit der Erfindung erzielbare Vorteil liegt insbesondere darin, daß wesentlich höhere den Thyristor durchfließende Lastströme durch Zuführung eines Löschspannungsimpulses an die Gateelektrode oder an das Gate der MIS-Emitter-Basis-Kurzschlußstruktur abgeschaltet werden können als das bisher möglich war.

Aus den IEEE Trans. on Electron Devices, Vol. ED-29, No. 6, 6/1982, S. 977-984, ist eine Multi-pn-Halbleiterstruktur bekannt, die aus einer Reihe von Halbleiterschichten alternierender Leitfähigkeiten mit einem Anodenkontakt an einer ersten, endseitigen, p-leitenden Schicht und einem Kathodenkontakt an einer zweiten, endseitigen, n-leitenden Schicht besteht. Hierbei handelt es sich im wesentlichen darum, die Durchbruchspannung einer im blockierenden Zustand betriebenen pnpn-Struktur mit der einer Multi-pn-Struktur zu vergleichen. Hinweise auf Maßnahmen zur Verbesserung des Abschaltverhaltens von abschaltbaren Thyristoren sind dieser Veröffentlichung jedoch nicht zu entnehmen.

Ferner ist aus "Patent Abstract of Japan", Vol.6, No.164 (E-127) [1042], 27/6/1982, & JP-A-57 83057 ein Thyristor bekannt, der mit einer zweiten, p-dotierten Basisschicht versehen ist. Diese zweite Basisschicht, die von einer Elektrode kontaktiert ist, ist in die n-leitende Basisschicht eingefügt und wird parallel zu der n-leitenden Basisschicht betrieben, um Schaltzeit und Basiswiderstand zu reduzieren.

Die Ansprüche 3 bis 5 sind auf bevorzugte Ausgestaltungen und Weiterbildungen der Erfindung gerichtet.

Die Erfindung wird nachfolgend anhand von bevorzugten Ausführungsbeispielen näher erläutert. Dabei zeigt:
- Fig. 1: einen erfindungsgemäß ausgebildeten, abschaltbaren Thyristor,
- Fig. 2: einen weiteren erfindungsgemäß ausgebildeten, abschaltbaren Thyristor,
- Fig. 3: das Dotierungsprofil der Thyristoren nach Fig. 1 oder Fig. 2,
- Fig. 4: eine beim Abschalten der Thyristoren nach Fig. 1 oder Fig. 2 auftretende Feldstärkeverteilung und
- Fig. 5: die Zeitabhängigkeit des Abschaltstroms bei Thyristoren nach Fig. 1 oder Fig. 2.

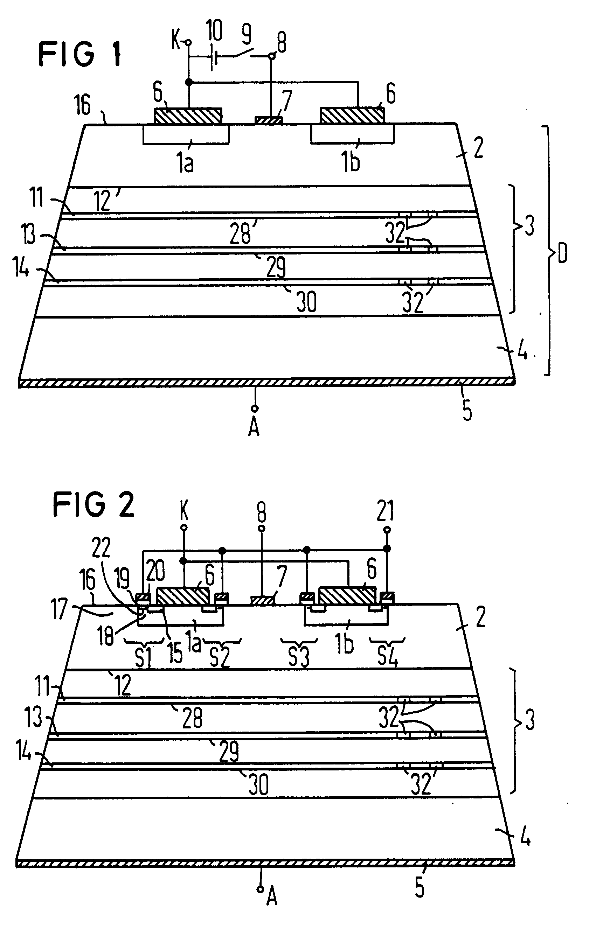

In Fig. 1 ist ein abschaltbarer Thyristor mit einem aus dotiertem Halbleitermaterial, z.B. Silizium, bestehenden Halbleiterkörper dargestellt. Er weist vier aufeinanderfolgende Schichten abwechselnder Leitungstypen auf. Von diesen bezeichnet man die aus den beiden n-leitenden Teilschichten 1a und 1b bestehende Schicht als den n-Emitter, die p-leitende Schicht 2 als die p-Basis, die n-leitende Schicht 3 als die n-Basis und die p-leitende Schicht 4 als den p-Emitter. Der p-Emitter ist mit einer anodenseitigen Elektrode 5 aus elektrisch leitendem Material, z.B. Aluminium, versehen, die einen Anschluß A aufweist. Der n-Emitter wird von einer mit einem Anschluß K versehenen kathodenseitigen Elektrode 6 aus elektrisch leitendem Material, z.B. Aluminium, kontaktiert. Eine mit einem Anschluß 8 versehene Gateelektrode 7 kontaktiert die p-Basis 2. Dem Anschluß 8 wird zum Zünden des Thyristors eine gegenüber K positive Zündspannung +U_{Z} zugeführt. Zum Abschalten bzw. Löschen des Thyristors wird ein Schalter 9 geschlossen, über den eine Spannungsquelle 10 zwischen K und den Anschluß 8 geschaltet wird. Hierbei wird die Gateelektrode 7 mit einem gegenüber dem Anschluß K negativen Löschspannungsimpuls -U_{L} beaufschlagt.

In die n-Basis 3 ist eine p-dotierte Halbleiterschicht 11 eingefügt, die im wesentlichen parallel zu dem mit 12 bezeichneten pn-Übergang zwischen der p-Basis 2 und der n-Basis 3 verläuft und im Vergleich zu der Dicke D des Halbleiterkörpers, die z. B. 400 µm beträgt, nur eine geringe Dicke von z.B. 4 µm aufweist. Mit 13 und 14 sind weitere p-leitende Halbleiterschichten bezeichnet, die in die n-Basis 3 unterhalb von der Halbleiterschicht 11 so eingefügt sind, daß sie untereinander etwa den gleichen Abstand aufweisen wie die Halbleiterschicht 13 von der Halbleiterschicht 11. Die etwa gleich dicken Schichten 11, 13 und 14 sind nicht mit äußeren Potentialen beschaltet, sondern stellen "floatende" Halbleiterschichten dar.

Fig. 2 zeigt einen weiteren, nach der Erfindung ausgebildeten, abschaltbaren Thyristor, dessen dem Thyristor nach Fig. 1 entsprechende Teile mit den gleichen Bezugszeichen versehen sind. Zum Unterschied von Fig. 1 ist in die Teilschicht 1a des n-Emitters ein p-leitendes Halbleitergebiet 15 eingefügt, das sich bis zur oberen Grenzfläche 16 des Halbleiterkörpers erstreckt und von der Elektrode 6 kontaktiert wird. Das Gebiet 15 bildet zusammen mit einem weiteren p-leitenden Halbleitergebiet 17, das aus einem sich an die Teilschicht 1a anschließenden Teilbereich der p-Basis 2 besteht, und einem zwischen 15 und 17 liegenden n-leitenden Kanalgebiet 18, das von einem durch eine elektrisch isolierende Schicht 19 von der Grenzfläche 16 getrennten Gate 20 überdeckt wird, eine MIS-FET-Struktur. Diese ist über einen Anschluß 21 des Gate 20 ansteuerbar. In einem ersten Schaltzustand dieser Struktur liegt bei 21 eine Gatespannung an, die negativer ist als die Einsatzspannung des Kanalgebiets 18 oder dieser entspricht. Dabei baut sich im Kanalgebiet 18 unterhalb von 20 ein Inversionskanal 22 auf, der das Gebiet 15 und damit die Elektrode 6 niederohmig mit dem Gebiet 17 und damit mit der p-Basis 2 verbindet, d.h. den pn-Übergang zwischen der Teilschicht 1a des n-Emitters und der p-Basis praktisch kurzschließt. In einem zweiten Schaltzustand dieser MIS-FET-Struktur ist der Anschluß 21 mit einer Spannung belegt, die die Einsatzspannung des Kanalgebiets 18 übersteigt. Hierbei ist der Inversionskanal 22 nicht vorhanden, so daß die niederohmige Verbindung bzw. der Kurzschluß zwischen 15 und 16 und damit zwischen 1a und 2 beseitigt ist. Neben der bereits beschriebenen MIS-FET-Struktur, die in Fig. 1 mit S1 bezeichnet ist, sind weitere analog aufgebaute MIS-FET-Strukturen S2 bis S4 auch am rechten Rand der Teilschicht 1a und an den Rändern der rechten Teilschicht 1b vorgesehen.

Zum Zünden des Thyristors nach Fig. 2 wird dem Anschluß 8 wieder eine positive Zündspannung +U_{Z} zugeführt, wobei sich die Strukturen S1 bis S4 jeweils im zweiten Schaltzustand befinden müssen. Die Abschaltung erfolgt zum Unterschied von Fig. 1 nicht über den Anschluß 8, sondern durch Zuführung eines negativen Löschspannungsimpulses -U_{L} an den Anschluß 21, durch den die Strukturen S1 bis S4 in den ersten Schaltzustand versetzt werden, in dem die pn-Übergänge zwischen 1a und 2 sowie zwischen 1b und 2 praktisch kurzgeschlossen sind.

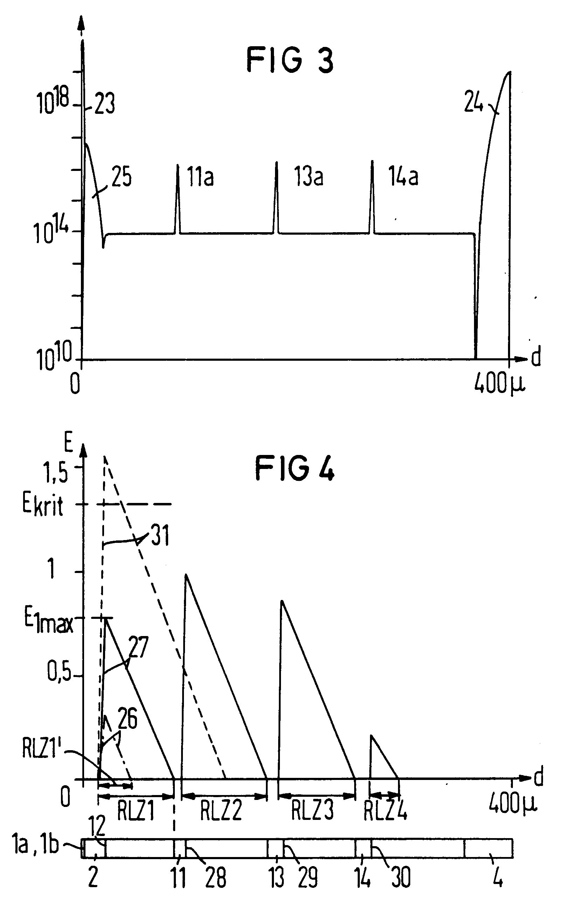

Fig. 3 zeigt das Dotierungsprofil der Thyristoren nach den Figuren 1 oder 2 in einem Diagramm, in dem die Dotierungskonzentration der einzelnen Halbleitergebiete über dem Abstand d von der Grenzfläche 16 des Halbleiterkörpers aufgetragen sind. Die etwa 10¹⁹cm⁻³ betragenden Dotierungskonzentrationen des n-Emitters und des p-Emitters sind jeweils durch die Profilabschnitte 23 und 24 gekennzeichnet, die etwa 10¹⁷cm⁻³ betragende Dotierungskonzentration der p-Basis durch den Profilabschnitt 25. Die in die mit 10¹⁴cm⁻³ dotierte n-Basis eingefügten p-leitenden Halbleiterschichten 11, 13, 14 sind durch die Profilabschnitte 11a, 13a und 14a angedeutet. Wie ersichtlich, beträgt die Dotierungskonzentration für diese Schichten etwa 10¹⁵-10¹⁶cm⁻³.

Im gezündeten bzw. stromführenden Zustand eines abschaltbaren Thyristors gemäß Fig. 1 oder Fig. 2 sind sämtliche sperrenden pn-Übergänge mit beweglichen Ladungsträgern überschwemmt, so daß sich für den von A nach K fließenden Laststrom ein niedrigerer Durchflußwiderstand ergibt.

Legt man nun zum Abschalten eines Thyristors nach Fig. 1 einen negativen Löschspannungsimpuls -U_{L} an die Gateelektrode 7 oder zum Abschalten eines Thyristors nach Fig. 2 einen solchen Impuls an den Anschluß 21, so werden zunächst die beweglichen Ladungsträger aus der p-Basis 2 entfernt, wobei schließlich der pn-Übergang 12 zwischen der p-Basis 2 und der n-Basis 3 in Sperrichtung gepolt wird. Am pn-Übergang 12 baut sich allmählich eine Raumladungszone RLZ1 auf.

In Fig. 4 ist die Verteilung der in 10⁵ V/cm angegebenen Feldstärke E des im Inneren der Raumladungszone RLZ1 vorhandenen, durch eine zwischen den Anschlüssen A und K anliegende Anoden-Kathodenspannung bedingten elektrischen Feldes wieder über dem Abstand d von der Grenzfläche 16 angegeben. Beim allmählichen Aufbau von RLZ1 wird zunächst eine Zwischenstufe erreicht, bei der die Raumladungszone eine Breite von RLZ1′ aufweist und die Feldstärkeverteilung durch die beiden strichpunktierten Geraden 26 gegeben ist. Die im Schnittpunkt dieser Geraden liegende maximale Feldstärke beträgt etwa 0,3 . 10⁵ V/cm. Der weitere Aufbau von RLZ1 kann nur so lange erfolgen, bis eine Feldstärkeverteilung erreicht ist, die durch die Geraden 27 gegeben ist, da hierbei die den größeren Abstand d aufweisende Begrenzung von RLZ1 gerade die obere Grenzfläche zwischen der Schicht 11 und der n-Basis 3 erreicht. Dies geht aus einem unterhalb des Diagramms in Fig. 4 dargestellten Querschnitt des Thyristors hervor. Da die durch den Schnittpunkt der Geraden definierte, maximale Feldstärke E₁ₘₐₓ wegen der Schicht 11 nicht überschritten werden kann, gelingt es, zu vermeiden, daß eine kritische Feldstärke Eₖᵣᵢₜ erreicht wird, bei der die RLZ1 durchlaufenden Ladungsträger einem Lawineneffekt ausgesetzt werden würden, durch den neue Ladungsträgerpaare entstehen könnten und die Raumladungszone RLZ1 die Funktion eines Ersatzemitters übernehmen würde. Hierbei wäre dann eine Abschaltung des Thyristors nicht mehr möglich. Das Entstehen eines Ersatzemitters im Bereich von RLZ1 wird also durch das Vorhandensein der Schicht 11 vermieden.

Im Anschluß an die Ausbildung von RLZ1 bauen sich nacheinander die Raumladungszone RLZ2 am pn-Übergang 28 zwischen den Teilen 11 und 3, die Raumladungszone RLZ3 am pn-Übergang 29 zwischen den Teilen 13 und 3 und RLZ4 am pn-Übergang 30 zwischen den Teilen 14 und 3 auf. Auch hier wird die Entstehung von Ersatzemittern dadurch vermieden, daß RLZ2 sich nur bis zur Schicht 13 hin ausdehnen kann und RLZ3 nur bis zur Schicht 14, so daß Eₖᵣᵢₜ in diesen Raumladungszonen nicht erreicht wird. Da die zwischen A und K anliegende Anoden-Kathoden-Spannung im wesentlichen schon durch die in RLZ1 bis RLZ3 auftretenden Potentialdifferenzen kompensiert wird, verbleibt für RLZ4 nur ein so kleiner Teil der Anoden-Kathoden-Spannung, daß RLZ4 schmäler ist als die übrigen Raumladungszonen, so daß auch hier Eₖᵣᵢₜ eindeutig unterschritten wird.

Wenn die Halbleiterschichten 11, 13 und 14 nicht vorhanden wären, würde die gesamte zwischen A und K liegende Anoden-Kathoden-Spannung in einer einzigen sich am pn-Übergang 12 aufbauenden Raumladungszone kompensiert werden müssen, was zu einer durch die gestrichelten Geraden 31 angedeuteten Feldstärkeverteilung führen würde. Dabei würde aber Eₖᵣᵢₜ überschritten werden, so daß keine sichere Abschaltung des Thyristors mehr erfolgen könnte.

Soll ein größerer Laststrom abgeschaltet werden als bisher vorausgesetzt wurde, so müssen die Geradenpaare 26, 27 usw. mit größerer Steilheit eingezeichnet werden. Aber auch in diesem Fall lassen sich maximale Feldstärken vermeiden, die oberhalb von Eₖᵣᵢₜ liegen, beispielsweise durch eine Verringerung der Abstände zwischen den Schichten 2, 11, 13 und 14.

Für Anwendungsfälle, in denen kleinere Lastströme abgeschaltet werden sollen oder kleinere Anoden-Kathoden-Spannungen vorgegeben sind, kann die Anzahl der Halbleiterschichten 11, 13, 14 verringert werden, so z.B. bis auf eine einzige Halbleiterschicht, während im gegenteiligen Fall auch eine größere Anzahl von Halbleiterschichten in die n-Basis eingefügt werden können.

Die bisher betrachteten Ausführungsformen der Erfindung werden durch weitere ergänzt, bei denen an der Anodenseite Maßnahmen getroffen werden, um beim Abschalten des Thyristors ein Ausräumen der in den Basisschichten vorhandenen Ladungsträger zu bewirken. Dabei handelt es sich beispielsweise um eine die n-Basis 3 kontaktierende Gateelektrode oder um steuerbare MIS-FET-Strukturen, die als Anoden-Basis-Kurzschlüsse dienen. Hierbei werden die Abstände der eingefügten Halbleiterschichten, z.B. 11, 13 und 14, vom p-Emitter so klein gewählt, daß sich die beim Abschalten des Thyristors aufbauenden Raumladungszonen keine maximalen Feldstärken aufweisen, die Eₖᵣᵢₜ überschreiten. Das gleiche gilt für Thyristoren, die in Rückwärtsrichtung sperren sollen, wobei der Anodenanschluß A auf niedrigerem Potential liegt als der Kathodenanschluß K.

Nach einer Weiterbildung der Erfindung sind die in eine Basisschicht eingefügten Halbleiterschichten, z.B. 11, 13 und 14, mit Ausnehmungen 32 versehen, die sie von ihren oberen bis zu ihren unteren Grenzflächen durchdringen. In lateraler Richtung sollen die Abmessungen dieser Ausnehmungen kleiner sein als die Dicken der Raumladungszone RLZ1 bzw. RLZ4 (Fig. 4). Hierdurch wird das Zündverhalten des Thyristors verbessert. Mit Vorteil können die Ausnehmungen 32 in den einzelnen Halbleiterschichten, z.B. 11, so angeordnet sein, daß sich für diese eine Gitterstruktur ergibt.

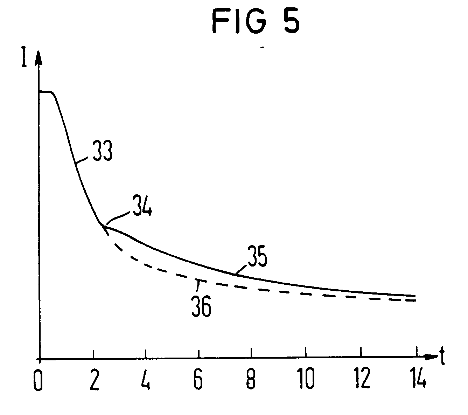

Fig. 5 zeigt die Abhängigkeit des Abschaltstroms I von der Zeit t, die in µs angegeben ist. Ein erster stark abfallender Ast 33 der Abschaltstrom/Zeit-Kurve entspricht dem Zeitraum, der zum Aufbau von RLZ1 benötigt wird. Durch das Ausräumen der Ladungsträger aus der Schicht 11 ergibt sich im Anschluß hieran eine Phase 34, in der der Abschaltstrom konstant bleibt. Der danach durchlaufene Kurvenast 35 entspricht dem Aufbau der nächsten Raumladungszone RLZ2. Die weiteren Schichten 13 und 14, die zu ähnlichen Phasen konstanter Abschaltstromstärke führen würden wie bei 34, wurden hierbei nicht berucksichtigt. Die gestrichelte Kurve 36 entspricht dem Abschaltstromverlauf ohne die eingefügten Schichten 11, 13 und 14, wobei angenommen ist, daß die Abschaltstromdichte so niedrig ist, daß die kritische Feldstärke Eₖᵣᵢₜ nicht überschritten wird.

Weitere Ausführungsformen der Erfindung ergeben sich dadurch, daß sämtliche Halbleitergebiete bzw. -schichten durch solche des entgegengesetzten Leitungstyps ersetzt werden, wobei die zugeführten Spannungen durch solche des entgegengesetzten Vorzeichens ersetzt werden.

In Abweichung von dem anhand von Fig. 2 beschriebenen Ausführungsbeispiel können die MIS-FET-Strukturen auch jeweils so ausgebildet sein, daß ihr erstes Halbleitergebiet aus einem Teil der Halbleiterschicht 1a bzw. 1b, ihr zweites Halbleitergebiet aus einem in die p-Basis 2 eingefügten, durch eine leitende Belegung mit der p-Basis 2 leitend verbundenen Kurzschlußgebiet und ihr von einem Gate überdecktes Kanalgebiet aus dem zwischen der Halbleiterschicht 1a bzw. 1b und dem Kurzschlußgebiet liegenden Teil der p-Basis 2 besteht. Derartige MIS-FET-Strukturen sind z.B. aus der US-A 4 224 634 bekannt.

## Patentansprüche

1. Abschaltbarer Thyristor mit einem Halbleiterkörper, der eine von einer kathodenseitigen Elektrode (6) kontaktierte n-Emitterschicht (1a, 1b) mit einer angrenzenden p-Basisschicht (2) und eine von einer anodenseitigen Elektrode (5) kontaktierte p-Emitterschicht (4) mit einer angrenzenden n-Basisschicht (3) aufweist, wobei die Basisschichten (2, 3) durch einen im blockierenden Zustand des Thyristors sperrenden pn-Übergang (12) voneinander getrennt sind, bei dem eine der Basisschichten (2) mit einer Gateelektrode (7) versehen ist, der ein die Abschaltung des Thyristors bewirkender Löschspannungsimpuls zuführbar ist, **dadurch gekennzeichnet,** daß in die von der Gateelektrode (7) nicht kontaktierte Basisschicht (3) wenigstens eine nicht mit äußeren Potentialen beschaltete, im wesentlichen parallel zum pn-Übergang (12) verlaufende, zu dieser Basisschicht (3) entgegengesetzt dotierte, im Vergleich zu der Dicke des Halbleiterkörpers dünne Halbleiterschicht (11) eingefügt ist, deren Abstand von dem pn-Übergang (12) so klein gewählt ist, daß die maximale Feldstärke (E₁ₘₐₓ) der sich beim Abschalten des Thyristors an diesem pn-Übergang (12) aufbauenden Raumladungszone (RLZ1) auf einen Wert begrenzt wird, der unter einem kritischen Wert (Eₖᵣᵢₜ) liegt, welcher zu einem Lawinendurchbruch bezüglich der beim Abschalten auszuräumenden Ladungsträger führt.

2. Abschaltbarer Thyristor mit einem Halbleiterkörper, der eine von einer kathodenseitigen Elektrode (6) kontaktierte n-Emitterschicht (1a, 1b) mit einer angrenzenden p-Basisschicht (2) und eine von einer anodenseitigen Elektrode (5) kontaktierte p-Emitterschicht (4) mit einer angrenzenden n-Basisschicht (3) aufweist, wobei die Basisschichten (2, 3) durch einen im blockierenden Zustand des Thyristors sperrenden pn-Übergang (12) voneinander getrennt sind, bei dem wenigstens eine der Emitterschichten (1a, 1b) mit wenigstens einer randseitigen MIS-FET-Struktur versehen ist, letztere bestehend aus einem ersten Halbleitergebiet (15) eines ersten Leitungstyps, das mit dieser Emitterschicht elektrisch leitend verbunden ist, aus einem zweiten Halbleitergebiet (17) des ersten Leitungstyps, das mit der angrenzenden Basisschicht (2) elektrisch leitend verbunden ist, und aus einem zwischen diesen Gebieten (15, 17) liegenden Kanalgebiet (18) eines zweiten Leitungstyps, das von einem durch eine dünne elektrisch isolierende Schicht (19) von der Oberfläche des Kanalgebiets (18) getrennten Gate (20) überdeckt ist, welches mit einem die Abschaltung des Thyristors bewirkenden Löschspannungsimpuls beaufschlagt wird, **dadurch gekennzeichnet**, daß in die Basisschicht (3), die mit dem zweiten Halbleitergebiet (17) nicht leitend verbunden ist, wenigstens eine nicht mit äußeren Potentialen beschaltete, im wesentlichen parallel zum pn-Übergang (12) verlaufende, zu dieser Basisschicht (3) entgegengesetzt dotierte, im Vergleich zu der Dicke des Halbleiterkörpers dünne Halbleiterschicht (11) eingefügt ist, deren Abstand von dem pn-Übergang (12) so klein gewählt ist, daß die maximale Feldstärke (E₁ₘₐₓ) der sich beim Abschalten des Thyristors an diesem pn-Übergang (12) aufbauenden Raumladungszone (RLZ1) auf einen Wert begrenzt wird, der unter einem kritischen Wert (Eₖᵣᵢₜ) liegt, welcher zu einem Lawineneffekt bezüglich der beim Abschalten auszuräumenden Ladungsträger führt.

3. Abschaltbarer Thyristor nach Anspruch 1 oder 2, **dadurch gekennzeichnet,** daß bei einer Mehrzahl von in eine Basisschicht (3) eingefügten, zu dieser entgegengesetzt dotierten, dünnen Halbleiterschichten (11, 13, 14) die Abstände zwischen diesen jeweils so klein gewählt sind, daß die maximalen Feldstärken der sich beim Abschalten des Thyristors zwischen den Halbleiterschichten (11, 13, 14) aufbauenden Raumladungszonen (RLZ2, RLZ3) auf Werte begrenzt werden, die jeweils unter dem genannten kritischen Wert (Eₖᵣᵢₜ) liegen.

4. Abschaltbarer Thyristor nach einem der Ansprüche 1 bis 3, **dadurch gekennzeichnet,** daß die in eine Basisschicht (3) eingefügten, zu dieser entgegengesetzt dotierten Halbleiterschichten (11, 13, 14) mit durchgehenden Ausnehmungen (32) versehen sind, deren Abmessungen in lateraler Richtung klein gegenüber der Dicke der jeweils angrenzenden, sich bei Abschaltung des Thyristors aufbauenden Raumladungszonen (RLZ1...RLZ4) sind.

5. Abschaltbarer Thyristor nach Anspruch 4, **dadurch gekennzeichnet,** daß die Ausnehmungen (32) der Halbleiterschichten (11, 13, 14) so angeordnet sind, daß sich eine gitterförmige Struktur dieser Halbleiterschichten ergibt.

## Claims

1. GTO thyristor having a semiconductor body which has an n-emitter layer (1a, 1b), contacted by a cathode-side electrode (6), with an adjoining p-base layer (2) and a p-emitter layer (4), contacted by an anode-side electrode (5), with an adjoining n-base layer (3), in which the base layers (2, 3) are separated from one another by a pn junction (12) inhibiting in the blocking condition of the thyristor, in which one of the base layers (2) is provided with a gate electrode (7), to which a quench voltage pulse effecting the turn-off of the thyristor can be fed, characterized in that into the base layer (3) not contacted by the gate electrode (7) there is inserted at least one semiconductor layer (11) which is not connected to external potentials, which extends substantially parallel to the pn junction (12) and which is oppositely doped to this base layer (3) and is thin in comparison with the thickness of the semiconductor body, the spacing of which semiconductor layer from the pn junction (12) is selected to be so small that the maximum field strength (E₁ₘₐₓ) of the space charge zone (RLZ1) building up at this pn junction (12) upon turn-off of the thyristor is limited to a value which is below a critical value (E_{crit}), which leads to an avalanche breakdown with respect to the charge carriers to be cleared out upon turn-off.

2. GTO thyristor having a semiconductor body which exhibits an n-emitter layer (1a, 1b), contacted by a cathode-side electrode (6), with an adjoining p-base layer (2) and a p-emitter layer (4), contacted by an anode-side electrode (5), with an adjoining n-base layer (3), in which the base layers (2, 3) are separated from one another by a pn junction (12) inhibiting in the blocking condition of the thyristor, in which at least one of the emitter layers (1a, 1b) is provided with at least one edge-side MIS-FET structure, the latter comprising a first semiconductor region (15) of a first conductivity type, which region is electrically conductively connected to this emitter layer, a second semiconductor region (17) of the first conductivity type, which region is electrically conductively connected to the adjoining base layer (2), and a channel region (18), situated between these regions (15, 17), of a second conductivity type, which is covered over by a gate (20) which is separated by a thin electrically insulating layer (19) from the surface of the channel region (18) and which is acted upon by a quench voltage pulse effecting the turn-off of the thyristor, characterized in that into the base layer (3) which is not conductively connected to the second semiconductor region (17) there is inserted at least one semiconductor layer (11) which is not connected to external potentials, which extends substantially parallel to the pn junction (12) and which is oppositely doped to this base layer (3) and is thin in comparison with the thickness of the semiconductor body, the spacing of which semiconductor layer from the pn junction (12) is selected to be so small that the maximum field strength (E₁ₘₐₓ) of the space charge zone (RLZ1) building up at this pn junction (12) upon turn-off of the thyristor is limited to a value which is below a critical value (E_{crit}), which leads to an avalanche effect with respect to the charge carriers to be cleared out upon turn-off.

3. GTO thyristor according to Claim 1 or 2, characterized in that in the case of a plurality of thin semiconductor layers (11, 13, 14) inserted into a base layer (3) and oppositely doped to the latter, the spacings between these are selected in each instance to be so small that the maximum field strengths of the space charge zones (RLZ2, RLZ3) building up between the semiconductor layers (11, 13, 14) upon turn-off of the thyristor are limited to values which are in each instance below said critical value (E_{crit}).

4. GTO thyristor according to one of Claims 1 to 3, characterized in that the semiconductor layers (11, 13, 14) which are inserted into a base layer (3) and which are oppositely doped to the latter are provided with through recesses (32), the dimensions of which in the lateral direction are small as compared with the thickness of the respectively adjoining space charge zones (RLZ1...RLZ4) building up upon turn-off of the thyristor.

5. GTO thyristor according to Claim 4, characterized in that the recesses (32) of the semiconductor layers (11, 13, 14) are disposed so that a lattice-shaped structure of these semiconductor layers results.

## Revendications

1. Thyristor blocable comportant un élément semiconducteur, qui comporte une couche (1a, 1b) d'émetteur de type n, qui est en contact avec une électrode (6) de cathode et a une couche (2) de base de type p voisine, et une couche (4) d'émetteur de type p, qui est en contact avec une électrode (5) d'anode et a une couche (3) de base de type n voisine, les couches (2, 3) de base étant séparées l'une de l'autre par une jonction (12) pn, qui réalise un blocage lors de l'état bloqué du thyristor, l'une (2) des couches de base étant munie d'une électrode (7) de gâchette, à laquelle on peut envoyer une impulsion en tension d'extinction provoquant le blocage du thyristor, caractérisé en ce que dans la couche (3) de base, qui n'est pas en contact avec l'électrode (7) de gâchette, est introduite au moins une couche (11) de semiconducteur, qui n'est branchée à aucun potentiel extérieur, qui s'étend essentiellement en parallèle à la jonction (12) pn, qui a un dopage de signe contraire à celui du dopage de cette couche (3) de base, qui est mince par rapport à l'épaisseur de l'élément semiconducteur et dont la distance à la jonction (12) pn est choisie si petite, que l'intensité (E₁ₘₐₓ) du champ maximal de la zone (RLZ1) de charge d'espace qui se forme dans cette jonction (12) pn lors du blocage du thyristor, est limitée à une valeur, qui se situe sous une valeur (Eₖᵣᵢₜ) critique, laquelle provoque un claquage par avalanche en ce qui concerne les porteurs de charge à évacuer lors du blocage.

2. Thyristor blocable comportant un élément semiconducteur, qui comporte une couche (1a, 1b) d'émetteur de type n, qui est en contact avec une électrode (6) de cathode et a une couche (2) de base de type p voisine, et une couche (4) d'émetteur de type p, qui est en contact avec une électrode (5) d'anode et a une couche (3) de base de type n voisine, les couches (2, 3) de base étant séparées l'une de l'autre par une jonction (12) pn, qui réalise un blocage lors de l'état bloqué du thyristor, au moins l'une des couches (1a, 1b) d'émetteur étant munie d'au moins une structure MIS-FET de bord, qui est constituée d'une première région (15) semiconductrice, qui a un premier type de conduction et est reliée par conduction électrique avec cette couche d'émetteur, d'une deuxième couche (17) semiconductrice, qui a le premier type de conduction et est reliée par conduction électrique avec la couche (2) de base voisine, et d'une région (18) de canal, qui est située entre ces deux régions (15, 17), a un deuxième type de conduction et est recouverte par une gâchette (20) qui est séparée de la surface supérieure de la région (18) de canal par une couche (19) mince d'isolation électrique et reçoit une impulsion de tension d'extinction provoquant le blocage du thyristor, caractérisé en ce que dans la couche (3) de base, qui est reliée de façon non conductrice avec la deuxième région (17) semiconductrice, est introduite au moins une couche (11) semiconductrice, qui n'est branchée à aucun potentiel extérieur, qui s'étend principalement en parallèle à la jonction (12) pn, qui a un dopage de signe opposé à celui du dopage de cette couche (3) de base, qui est mince par rapport à l'épaisseur de l'élément semiconducteur et dont la distance à la jonction (12) pn est choisie si petite, que l'intensité (E₁ₘₐₓ) maximale du champ dans la zone (RLZ1) de charge d'espace qui se forme dans cette jonction (12) pn lors du blocage du thyristor est limitée à une valeur, qui est inférieure à une valeur (Eₖᵣᵢₜ) critique, laquelle provoque un effet d'avalanche en ce qui concerne les porteurs de charge à évacuer lors du blocage.

3. Thyristor blocable suivant la revendication 1 ou 2, caractérisé en ce que pour plusieurs couches (11, 13, 14) semiconductrices minces, qui sont introduites dans une couche (3) de base, qui ont un dopage de signe opposé à celui du dopage de cette couche de base, les distances entre ces couches sont chacune choisies si petites, que les intensités maximales de champ dans les zones (RLZ2, RLZ3) de charge d'espace, qui se forment entre les couches (11, 13, 14) semiconductrices lors du blocage du thyristor, sont limitées à des valeurs, qui sont chacune inférieures à ladite valeur (Eₖᵣᵢₜ) critique.

4. Thyristor blocable suivant l'une des revendications 1 à 3, caractérisé en ce que les couches (11, 13, 14) semiconductrices, qui sont introduites dans une couche (3) de base et ont un dopage de signe opposé à celui de cette couche, sont pourvues de creux (32) les traversant, dont les dimensions dans la direction latérale sont petites par rapport à l'épaisseur des zones (RLZ1...RLZ4) voisines de charge d'espace, qui se forment lors du blocage du thyristor.

5. Thyristor blocable suivant la revendication 4, caractérisé en ce que les creux (32) des couches (11, 13, 14) semiconductrices sont disposés, de sorte à obtenir une structure en forme de treillis pour ces couches semiconductrices.
